Europäisches Patentamt

European Patent Office

Office européen des brevets

(19)

(11) Veröffentlichungsnummer: **0 379 900**
**A2**

## (12) EUROPÄISCHE PATENTANMELDUNG

(21) Anmeldenummer: **90100533.0**

(22) Anmeldetag: **11.01.90**

(51) Int. Cl.⁵: **H03K 17/08**

(30) Priorität: **23.01.89 DE 3901890**

(43) Veröffentlichungstag der Anmeldung:
**01.08.90 Patentblatt 90/31**

(84) Benannte Vertragsstaaten:
**AT CH DE FR GB IT LI SE**

(71) Anmelder: **Siemens Aktiengesellschaft**
**Wittelsbacherplatz 2**
**D-8000 München 2(DE)**

(72) Erfinder: **Laber, Hans, Dipl.-Ing.**
**Schwedlerstrasse 31**
**D-8520 Erlagnen(DE)**

(54) **Beschaltung eines oder mehrerer Halbleiterventile mit Sperrfähigkeit in Rückwärtsrichtung.**

(57) Halbleiterventile mit Sperrfähigkeit in Rückwärtsrichtung sind zur Begrenzung positiver Überspannungen mit einem Entlastungszweig aus einem Entlastungskondensator Cs und einer Diode Ds mit einem Parallelwiderstand R beschaltet. Beim Abkommutieren des Stromes auf den Entlastungszweig bildet sich ein Rückstrom aus, der mit einer steilen Flanke abreißen und zu gefährlichen negativen Überspannungen führen kann. Zur Entlastung des Ventils gegenüber diesen Überspannungen ist ein Hilfskondensator Cd zur Diode Ds parallel geschaltet. In Reihe mit dem Halbleiterventil ist eine Sättigungsdrossel Lk mit einem Parallelwiderstand Rk angeordnet.

FIG 2

EP 0 379 900 A2

**Beschaltung eines oder mehrerer Halbleiterventile mit Sperrfähigkeit in Rückwärtsrichtung**

Die Erfindung betrifft eine Beschaltung eines Halbleiterventiles mit Sperrfähigkeit in Rückwärtsrichtung, insbesondere eines Abschaltthyristors, mit den im Oberbegriff des Anspruchs 1 genannten Merkmalen. Die Erfindung betrifft ferner eine Beschaltung von mehreren in Reihe liegender Halbleiterventile, insbesondere Abschaltthyristoren, mit Sperrfähigkeit in Rückwärtsrichtung mit den im Oberbegriff des Anspruchs 6 angegebenen Merkmalen.

Wird an Schaltungen mit Halbleiterventilen mit Sperrfähigkeit in Rückwärtsrichtung, insbesondere Abschaltthyristoren ("GTO-Thyristoren") eine negative Spannung gelegt, so erfolgt das Abkommutieren eines positiven Anodenstromes meist mit einer großen Stromsteilheit, wodurch sich ein hoher Rückstrom ergibt. In der Regel ist dem GTO-Thyristor ein Entlastungszweig parallelgeschaltet, auf den dieser Rückstrom kommutiert wird.

Dieser Entlastungszweig ist meist mit einer unvermeidlichen parasitären Induktivität behaftet. Beim Kommutieren des steil abreißenden Rückstroms ("snap off") auf den Entlastungszweig können dann hohe Überspannungen auftreten, die das Halbleiterventil gefährden und durch geeignete Mittel begrenzt werden müssen.

Außerdem reißen bei einer Reihenschaltung derartiger Halbleiterventile die Rückströme der einzelnen Ventile und ihrer Beschaltungen nicht gleichzeitig ab, so daß die dynamischen Überspannungen ungleich auf die Ventile verteilt sein können. Dadurch wird die Schaltbarkeit von Reihenschaltungen erheblich eingeschränkt.

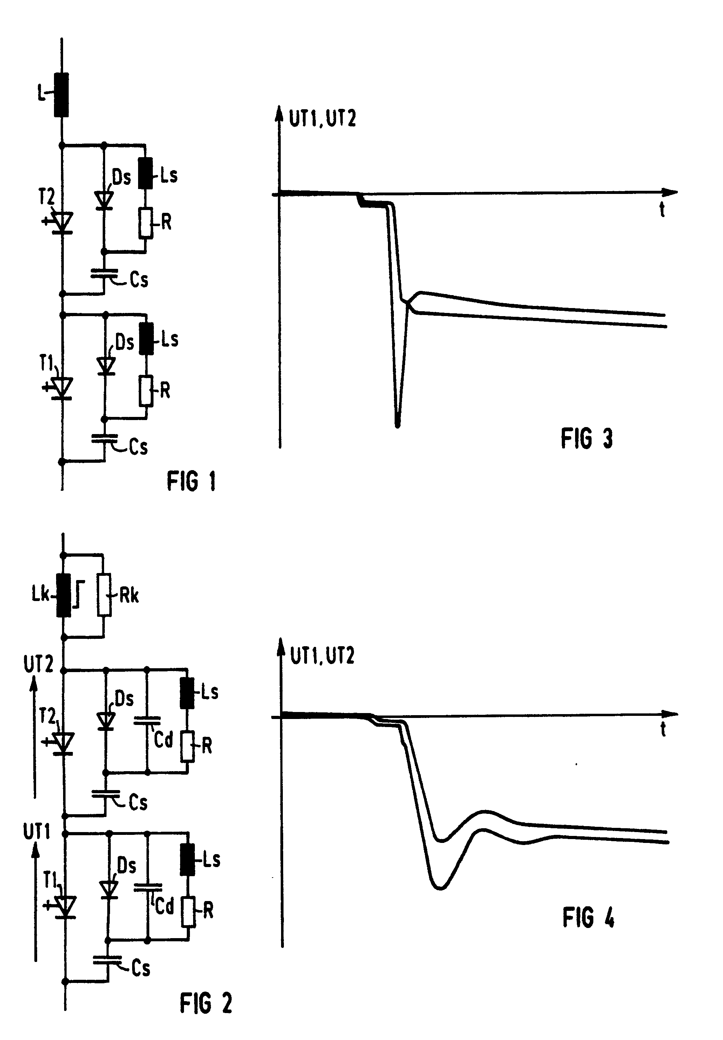

In Fig. 1 ist eine bekannte Reihenschaltung von GTO-Thyristoren T1, T2, ... mit jeweils einem Entlastungszweig gezeigt, der in der dargestellten Weise jeweils aus einer Diode Ds, einem Entlastungskondensator Cs und einem Widerstand Rs besteht. Mit Ls ist eine Induktivität des Entlastungszweiges dargestellt, die die parasitäre Induktivität der Beschaltung charakterisiert. Gemäß der Veröffentlichung "Symmetrical GTO current source inverter for wide speed range control of 2300 to 4160 Volt, 350 to 7000 HP induction motor" von P.M. Espelage, J.M.Nowak, L.H.Walker, IEEE 1988, Seite 302 - 307, Fig. 2 und Fig. 10, ist in Reihe mit den Thyristoren eine lineare Induktivität L geschaltet, die sowohl die Steilheit des abkommutierenden Laststroms wie auch den Rückstrom soweit begrenzt, daß dessen Abreißen an der parasitären Induktivität keine unzulässige Überspannung erzeugt.

Diese bekannte Schaltung führt jedoch zu langen Kommutierungszeiten, die insbesondere Anwendungen bei gepulsten Stromrichterschaltungen mit höherer Pulsfrequenz ausschließen.

Der Erfindung liegt die Aufgabe zugrunde, für Halbleiterventile, insbesondere abschaltbare Halbleiterventile, mit Sperrfähigkeit in Rückwärtsrichtung eine Beschaltung anzugeben, die Überspannungen, die durch ein steiles Abreißen des Rückstromes entstehen können, auf andere Weise zu begrenzen gestattet.

Gemäß der Erfindung wird diese Aufgabe gelöst durch eine Beschaltung mit den Merkmalen des Anspruchs 1. Eine besonders vorteilhafte Lösung der Aufgabe für eine Reihenschaltung derartiger Ventile ist durch die Merkmale des Anspruchs 6 gekennzeichnet.

Vorteilhafte Weiterbildungen der Erfindung sind in den Unteransprüchen angegeben und werden anhand von drei weiteren Figuren erläutert.

Es zeigen:

Fig. 1 die bereits erläuterte, bekannte Beschaltung,

Fig. 2 ein vorteilhaftes Ausführungsbeispiel der Erfindung,

Fig. 3 den Verlauf der Thyristorspannungen bei einer Schaltung mit Fig. 2, die jedoch keinen Hilfskondensator Cd aufweist,

Fig. 4 den Verlauf dieser Spannungen, wenn in Fig. 2 ein Hilfskondensator verwendet wird.

Der Erfindung liegt der Gedanke zugrunde, auch für den abreißenden Rückstrom ("snap-off") einen niederinduktiven Entlastungszweig für die Rückwärtszweig zu schaffen. Daher ist zunächst vorgesehen, die in Fig. 1 gezeigte Beschaltung durch einen Hilfszweig zu ergänzen, der einen Hilfskondensator Cd enthält und parallel zur Diode geschaltet ist.

Vorteilhaft wird die Induktivität dieses Hilfszweiges möglichst niedrig gehalten, was z.B. dadurch erreicht werden kann, daß der Hilfskondensator Cd direkt parallel zur Diode Ds geschaltet und räumlich möglichst nahe bei ihr angeordnet ist. Vorteilhaft weisen auch die Kondensatoren Cs und Cd nur eine geringe Eigeninduktivität auf, um die Reihenschaltung möglichst niederinduktiv zu halten.

Eine lineare Induktivität L, wie sie in Fig. 1 vorgeschlagen ist, um die Steilheit des abkommutierenden Laststroms und des Rückstroms zu begrenzen, ist bei der Erfindung im Hinblick auf das Abschalten des Stromes nicht vorgeschrieben. Statt dessen ist jedoch in Fig. 2 Eine Induktivität vorgesehen, die als sättigbare Drosselspule Lk ("Sättigungsdrossel") mit einem Parallelwiderstand Rk ausgebildet ist.

Beim Abschalten kann sich die Sättigungsdrossel Lk über ihren Parallelwiderstand Rk entsättigen, wobei der Parallelwiderstand Rk außerdem eine definierte Begrenzung des Rückstroms bewirkt, also eine weitere Verminderung der Überspannung.

Wegen dieser Begrenzung des Rückstroms über das Beschaltungselement Lk, Rk kann die Kapazität des Hilfskondensators Cd kleiner, insbesondere erheblich kleiner als die Kapazität des Entlastungskondensators Cs, gewählt werden.

In Fig. 3 ist die Schaltung nach Fig. 2 unter Verzicht auf den erfindungsgemäßen Hilfskondensator Cd angewendet. Die beiden Thyristorspannung UT1 und UT2 sind beim gleichzeitigen Abschalten beider GTO-Thyristoren dargestellt. Man erkennt, daß an einem Thyristor eine erhebliche negative Spannungsspitze auftritt, die etwa doppelt so hoch ist wie der Wert der stationären Sperrspannung.

Fig. 4 zeigt den gleichen Vorgang unter Verwendung des Hilfskondensators Cd, wobei nunmehr beide Thyristoren praktisch gleichzeitig eine negative Spannungsspitze aufweisen, die jedoch wesentlich abgeflacht ist. Ohne das Beschaltungsglied Lk, Rk würden in beiden Fällen die negativen Spannungsspitzen wesentlich größer ausfallen.

**Ansprüche**

1. Beschaltung eines Halbleiterventiles (T2), insbesondere eines abschaltbaren Halbleiterventiles, mit Sperrfähigkeit in Rückwärtsrichtung, mit folgenden Merkmalen:
a) zur Begrenzung einer positiven Überspannung beim Abkommutieren des Stromes ist dem Halbleiterventil eine Reihenschaltung aus einer Diode (Ds) und einem Entlastungskondensator (Cs) parallel geschaltet, und
b) der Diode ist ein Widerstand (Rs) parallel geschaltet,
**gekennzeichnet durch** einen zur Diode parallel geschalteten Hilfszweig mit einem Hilfskondensator (Cd). (Fig. 2)

2. Beschaltung nach Anspruch 1, **dadurch gekennzeichnet,** daß der Hilfszweig eine möglichst niedrige Induktivität aufweist.

3. Beschaltung nach Anspruch 1, **dadurch gekennzeichnet,** daß der über den Entlastungskondensator und den Hilfskondensator führende Strompfad eine möglichst niedrige Induktivität aufweist.

4. Beschaltung nach Anspruch 1, **dadurch gekennzeichnet,** daß dem Halbleiterventil eine Sättigungsdrossel (Lk) mit einem Parallelwiderstand (Rk) in Reihe geschaltet ist.

5. Beschaltung nach Anspruch 1 oder 4, **dadurch gekennzeichnet,** daß die Kapazität des Hilfskondensators kleiner als die Kapazität des Entlastungskondensators ist.

6. Beschaltung für mehrere in Reihe liegende Halbleiterventile, insbesondere abschaltbare Halbleiterventile, mit Sperrfähigkeit in Rückwärtsrichtung, mit folgenden Merkmalen:
a) zur Begrenzung einer positiven Überspannung beim Abkommutieren des Stromes ist jedem Halbleiterventil eine Reihenschaltung aus einer Diode und einem Entlastungskondensator parallel geschaltet,
b) jeder Diode ist ein Widerstand parallel geschaltet,
**gekennzeichnet durch** folgende weitere Merkmale:
c) zu jeder Diode ist ein Hilfszweig mit je einem Hilfskondensator parallel geschaltet, und
d) in Reihe mit den Halbleiterventilen ist eine Sättigungsdrossel mit einem Parallelwiderstand in Reihe geschaltet.

7. Beschaltung nach Anspruch 6, **dadurch gekennzeichnet,** daß die Reihenschaltung aus Entlastungskondensator und Diode und der dazu parallele Hilfszweig eine möglichst niedrige Induktivität aufweisen.

8. Beschaltung nach Anspruch 6, **dadurch gekennzeichnet,** daß die Kapazität des Hilfskondensators kleiner als die Kapazität des Entlastungskondensators ist.

FIG 1

FIG 3

FIG 2

FIG 4